# EUROPÄISCHE PATENTSCHRIFT

(11) **EP 0 410 108 B1**
(45) Veröffentlichungstag und Bekanntmachung des Hinweises auf die Patenterteilung: **07.07.1993**
(21) Anmeldenummer: 90109974.7
(22) Anmeldetag: 25.05.1990
(51) Int. Cl.: B60R 21/32

(54) **Steueranordnung für ein Rückhaltesystem in Kraftfahrzeugen**
Control arrangement for a restraining system in motor cars
Dispositif de commande pour un système de retenue dans des voitures

(30) Priorität: 25.07.1989 DE 3924595
(43) Veröffentlichungstag der Anmeldung: 30.01.1991
(73) Patentinhaber: BECKER GmbH, D-76307 Karlsbad (DE)
(72) Erfinder: Gesper, Christoph, D-7519 Walzbachtal 1 (DE); Heyden, Siegfried, D-7530 Pforzheim (DE)
(74) Vertreter: Bauer, Rudolf, Dr.

(56) Entgegenhaltungen:
- DE-A- 3 001 780
- DE-A- 3 400 533
- DE-A- 3 729 020
- DE-C- 3 736 296
- US-A- 4 359 715
- US-A- 4 366 465

## Beschreibung

Die Erfindung betrifft eine Steueranordnung für ein Rückhaltesystem in Kraftfahrzeugen, mit einem die von einem Beschleunigungsaufnehmer abgegebenen Meßsignale auswertenden Mikrocomputer, der ein Auslösesignal an eine Auslösevorrichtung des Rückhaltesystems abgibt, wenn die Auswertung des Meßsignals ein Kriterium zur Aktivierung des Rückhaltesystems erfüllt.

Eine Steueranordnung dieser Art ist beispielsweise aus der DE-PS 30 01 780 bekannt. Der Mikrocomputer überwacht ständig das von dem Beschleunigungsaufnehmer abgegebene Meßsignal und wertet dieses aus, um im Bedarfsfall ein Auslösesignal an die Auslösevorrichtung des Rückhaltesystems abzugeben. Bei dem Rückhaltesystem kann es sich um ein Gassack-Schutzkissensystem oder auch um ein Sicherheitsgurtsystem mit Gurtstraffereinrichtung handeln.

An derartige Steueranordnungen werden allerhöchste Ansprüche bezüglich Funktionssicherheit und Zuverlässigkeit gestellt. Eine Auslösung im Bedarfsfalle muß ebenso sicher gewährleistet sein wie eine Fehlauslösung verhindert werden muß. Da für die komplexe Aufgabe der Signalauswertung und Bestimmung der optimalen Auslösezeitpunkte ein Mikrocomputer benötigt wird, enthält die Steueranordnung ein für ihre Funktion wesentliches Bauelement, das aufgrund der in einem Kraftfahrzeug vorherrschenden Bedingungen zahlreichen Störungen ausgesetzt sein kann. Es besteht daher ein Bedarf für eine Überwachungsanordnung, welche die Funktionen des Mikrocomputers und die für seinen einwandfreien Betrieb einzuhaltenden Betriebsgrößen mit höchster Zuverlässigkeit überwacht.

Der Erfindung liegt die Aufgabe zugrunde, eine diese Forderung erfüllende Überwachungsschaltung zur Verfügung zu stellen. Insbesondere liegt der Erfindung die Aufgabe zugrunde, eine Steueranordnung der genannten Art mit einer Überwachungsschaltung zu versehen, die alle relevanten Fehlfunktionen zuverlässig erkennt und beim Auftreten einer Fehlfunktion die Aktivierung des Rückhaltesystems verhindert.

Diese Aufgabe wird bei einer Steueranordnung der eingangs angegebenen Art erfindungsgemäß durch eine bezüglich des Mikrocomputers erxterne Überwachungsschaltung gelöst, die ein von dem Mikrocomputer-Taktsignal abgeleitetes Prüfsignal mittels einer durch einen eigenen stabilen Oszillator angesteuerten Zähleinrichtung auf korrekte Frequenz überwacht, ein Freigabesignal erzeugt, wenn das Prüfsignal die korrekte Frequenz aufweist, eine Anzeigeeinrichtung aktiviert, wenn das Prüfsignal als nicht korrekt befunden wird, und ansprechend auf das Freigabesignal die Weiterleitung des Auslösesignals an die Auslösevorrichtung verhindert, wenn das Prüfsignal als nicht korrekt befunden wird. Die Erfindung beruht auf der Erkenntnis, daß ein wichtiges Kriterium für eine einwandfreie Funktion des Mikrocomputers darin besteht, daß sein Taktsignal die vorgeschriebene Frequenz aufweist.

Die Überprüfung der Taktfrequenz als Kriterium für die einwandfreie Funktion eines Mikrocomputers in einer Steueranordnung für Rückhaltesysteme ist aber problematisch, weil sie innerhalb einer sehr kurzen Zeitspanne erfolgen muß, die im Grenzfall zwischen der Abgabe eines Auslösesignals durch den Mikrocomputer und der Weiterleitung desselben an die Auslösevorrichtung des Rückhaltesystems liegt. Wenn der Mikrocomputer ein Auslösesignal abgibt, muß innerhalb einer Zeitspanne, die klein gegenüber der Zeitspanne für die Aktivierung des Rückhaltesystems ist, überprüft werden, ob der Mikrocomputer einwandfrei arbeitet, wozu es insbesondere erforderlich ist, seine Taktfrequenz zu überprüfen. Dies kann mittels Zählschaltungen oder Timer-Schaltungen geschehen. Für die Funktion dieser Schaltungen ist jedoch wiederum ein Taktsignal erforderlich. Ohne ein externes, stabiles Taktsignal ist daher keine Überprüfung der Taktfrequenz des Mikrocomputer-Taktsignals möglich. Erfindungsgemäß wird daher die Überwachungsschaltung mit einem eigenen, stabilen Oszillator ausgestattet. Es ist nunmehr nicht nur möglich, das Taktsignal des Mikrocomputers zu überwachen, sondern auch die Funktion der Überwachungsschaltung selbst. Wenn nämlich der Oszillator der Überwachungsschaltung fehlerhaft arbeiten sollte, ergibt die Auswertung selbst eines einwandfreien Mikrocomputer-Taktsignals ein fehlerhaftes Ergebnis, weil die zur Frequenzmessung benutzte Referenzgröße ihrerseits fehlerhaft ist.

Eine Besonderheit der erfindungsgemäßen Steueranordnung besteht somit darin, daß auch das gleichzeitige Auftreten von zwei Fehlern, nämlich eines Fehlers im Bereich des Mikrocomputers und eines Fehlers im Bereich der Überwachungsschaltung selbst, nicht zu einer Fehlauslösung führen kann.

Bei der bevorzugten Ausführungsform der Steueranordnung spricht die Auslösevorrichtung nur auf das gleichzeitige Vorhandensein von zwei Auslösesignalen an, von denen das eine der Mikrocomputer direkt abgibt und über eine Sperrstufe geführt wird, die durch die Überwachungsschaltung gesteuert wird, und das andere in der Überwachungsschaltung um eine Zeitspanne verzögert wird, die für die Überprüfung des Taktsignals des Mikrocomputers ausreicht. Diese Zeitspanne liegt in der Größenordnung von einigen hundert µs und ist gegenüber der Aktivierungszeit des Rückhaltesystems ausreichend kurz. Da die Überwachungsschaltung Fehler in der Funktion des Mikrocomputers erst nach einer bestimmten Auswertezeit feststellen kann, wird ein vom Mikrocomputer abgegebenes Auslösesignal in der Überwachungsschaltung verzögert und nur dann an die Auslösevorrichtung weitergeleitet, wenn während der Verzögerungszeit kein Fehler festgestellt wurde. Durch diese Ausgestaltung wird eine Fehlauslösung auch dann verhindert, wenn ein Fehler innerhalb einer sehr kurzen, der Abgabe eines Auslösesignals unmittelbar vorausgehenden Zeitspanne aufgetreten ist, die für eine Fehlererkennung durch die Überwachungsschaltung nicht ausreicht. In allen anderen, sehr viel wahrscheinlicheren Fehlerfällen führt das Fehlen des in der Überwachungsschaltung erzeugten Freigabesignals dazu, daß ein vom Mikrocomputer abgegebenes Auslösesignal in der Sperrstufe abgefangen wird.

Eine besonders einfache Auswertung des vom Mikrocomputer direkt abgegebenen Auslösesignals und des von der Überwachungsschaltung verzögert weitergegebenen Auslösesignals besteht in einer Reihenschaltung von zwei Transistoren mit einem elektrischen Zünder. Besonders zweckmäßig ist eine Reihenschaltung von zwei Schalttransistoren, zwischen denen der elektrische Zünder angeordnet ist. Durch Wahl geeigneter Ansteuerpotentiale beider Schalttransistoren wird erreicht, daß die Reihenschaltung aus Transistoren und Zünder nur dann durchschaltet, wenn beide Transistoren leitend sind.

Neben der Taktfrequenz des Mikrocomputers überwacht die Überwachungsschaltung vorzugsweise auch alle für die Funktion der Steueranordnung relevanten Betriebsspannungen. Nur wenn diese Betriebsspannungen innerhalb der vorgesehenen Werte bereiche liegen, kann das Freigabesignal an den Mikrocomputer abgegeben werden.

Wenn die Überwachungsschaltung einen Fehler feststellt, gibt sie überdies bei der bevorzugten Ausführungsform ein Ansteuersignal an eine Kontrollampe ab, die den Fahrzeugbenutzer darüber informiert, daß eine einwandfreie Funktion des Rückhaltesystems nicht gewährleistet ist. Der Fahrzeugbenutzer ist dann aufgefordert, eine Werkstatt aufzusuchen und den Fehler beheben zu lassen.

Eine weitere Steigerung der Betriebssicherheit wird bei der bevorzugten Ausführungsform dadurch erreicht, daß das von der Taktfrequenz des Mikrocomputers abgeleitete Prüfsignal in einer gesonderten Auswerteschaltung auf das Vorhandensein einer Wechselspannungskomponente überprüft wird. Die Kontrollampe wird durch die Auswerteschaltung auch dann angesteuert, wenn keine Wechselspannungskomponente vorhanden ist. Auf diese Weise führt das Ausbleiben der Mikrocomputer-Taktfrequenz auch dann zu einer Fehlermeldung, wenn die Überwachungsschaltung selbst fehlerhaft arbeitet und den Fehler nicht erkennt.

Damit das kurzzeitige Auftreten eines Fehlers nicht zur Funktionsuntüchtigkeit des Systems führt, ist weiterhin bei der bevorzugten Ausführungsform vorgesehen, daß die Überwachungsschaltung nach dem Erkennen eines Fehlers ein Rücksetzsignal an den Mikrocomputer abgibt. Der Mikrocomputer wird dann neu gestartet und kann seine normale Funktion wiederaufnehmen, solange keine Fehler auftreten. Dauert der Fehlerzustand an, gibt die Überwachungsschaltung periodisch Rücksetzsignale an den Mikrocomputer ab.

Die Überwachungsschaltung wird vorzugsweise in einer Technologie ausgeführt, die gegenüber der Technologie des Mikrocomputers eine deutlich höhere Spannungsfestigkeit aufweist. Es besteht daher eine große Wahrscheinlichkeit, daß die Überwachungsschaltung unbeschädigt bleibt, wenn der Mikrocomputer aufgrund einer Betriebsspannungsspitze beschädigt wird.

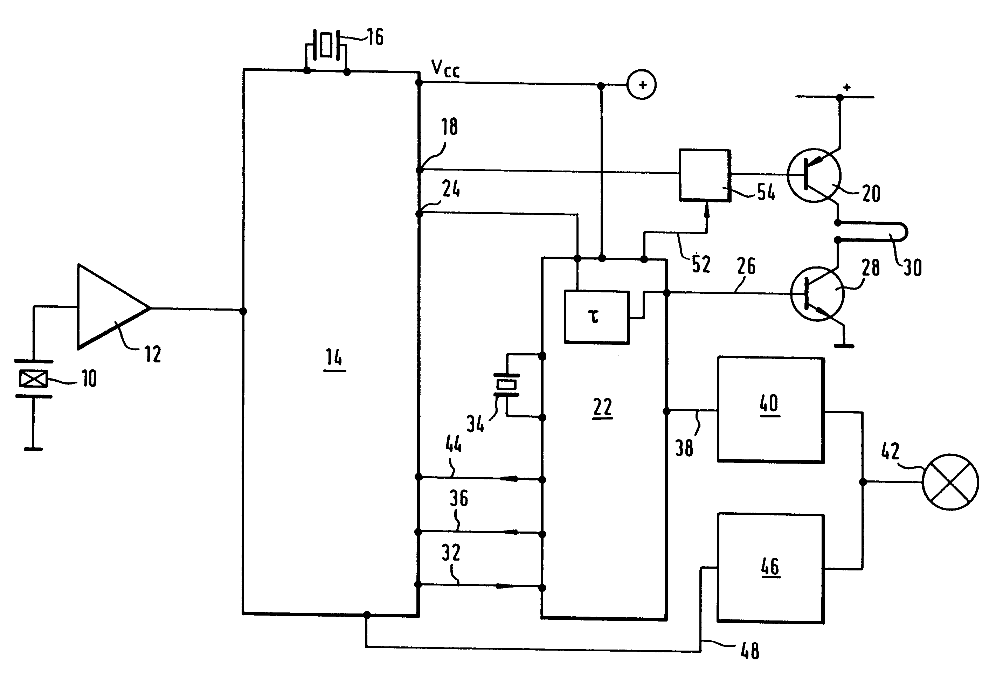

Einzelheiten einer bevorzugten Ausführungsform der Erfindung ergeben sich aus der nachfolgenden Beschreibung unter Bezugnahme auf die Zeichnung. Die einzige Figur der Zeichnung zeigt ein vereinfachtes Blockschaltbild der Steueranordnung mit Überwachungsschaltung.

Die Steueranordnung verarbeitet ein von einem piezoelektrischen Beschleunigungsaufnehmer 10 erzeugtes Meßsignal, das über einen Anpassungsverstärker 12 an einen Signaleingang eines Mikrocomputers 14 angeschlossen ist, der über einen A/D-Wandler verfügt. Der Mikrocomputer ist in bekannter Weise mit einer Zentralprozessoreinheit (CPU), einem Festwertspeicher (ROM), einem Arbeitsspeicher (RAM) und mit Ein/Ausgabe-Schaltungen versehen. Die Taktfrequenz des Mikrocomputers 14 wird durch einen externen Schwingquarz 16 bestimmt. Zur Spannungsversorgung wird an den Mikrocomputer 14 eine stabilisierte Spannung Vcc angelegt.

An seinem mit 18 bezeichneten Anschluß gibt der Mikrocomputer 14, wenn ein bestimmtes Auslösekriterium erfüllt ist, ein Auslösesignal an den Signaleingang einer Sperrstufe 54 ab, deren Steuereingang über eine Leitung 52 mit der Überwachungsschaltung 22 und deren Signalausgang mit der Basis eines Schalttransistors 20 verbunden ist. Um zu bestimmen, ob das Auslösekriterium erfüllt ist, führt der Mikrocomputer 14 eine Auswertung des vom piezoelektrischen Beschleunigungsaufnehmer 10 über den Anpassungsverstärker 12 gelieferten Meßsignals durch. Das Ergebnis der Auswertung hängt unter anderem von der korrekten Taktfrequenz des Mikrocomputers ab.

Zur Überwachung aller für die Funktion der Steueranordnung relevanten Größen ist eine Überwachungsschaltung 22 vorgesehen. Der Mikrocomputer 14 gibt über seinen Ausgang 24 das Auslösesignal an die Überwachungsschaltung 22 ab, die einen Verzögerungskreis, beispielsweise eine monostabile Kippschaltung, enthält, welcher das Auslösesignal um eine feste Zeitspanne τ verzögert. Das Ausgangssignal des Verzögerungskreises wird über eine Leitung 26 an die Basis eines zweiten Schalttransistors 28 angelegt, der mit dem Schalttransistor 20 unter Zwischenfügung eines elektrischen Zünders 30 zwischen den Pluspol der Versorgungsspannung und Masse in Reihe geschaltet ist. Die Schalttransistoren 20, 28 sind von entgegengesetztem Leitungstyp. Nur wenn beide Schalttransistoren 20, 28 durchgeschaltet sind, erhält der elektrische Zünder 30 die für seine Aktivierung erforderliche Ansteuerspannung.

Die Überwachungsschaltung 22 empfängt über eine Leitung 32 aus dem Mikrocomputer 14 ein von dessen Taktsignal abgeleitetes Prüfsignal. Dieses Prüfsignal wird beispielsweise in dem Mikrocomputer 14 durch Herunterteilen des Taktsignals von 6 MHz auf 1 kHz erzeugt. In der Überwachungsschaltung 22 wird dieses Prüfsignal ausgewertet und auf korrekte Frequenz überprüft. Diese Überprüfung erfolgt mittels Zählschaltungen, die ihrerseits ein stabiles Taktsignal benötigen. Dieses Taktsignal wird mittels eines eigenen Oszillators der Überwachungsschaltung 22 erzeugt. Die Schwingungsfrequenz dieses Ozsillators wird durch einen Schwingquarz 34 bestimmt. Solange die Prüfschaltung 22 eine korrekte Frequenz des Prüfsignals feststellt, erzeugt ein Freigabesignal, das auch über eine Leitung 36 an den Mikrocomputer 14 abgegeben wird. Dem Freigabesignal auf Leitung 36 entspricht ein Steuersignal, das über Leitung 52 an die Sperrstufe 54 angelegt wird und diese befähigt, das Ansteuersignal vom Ausgang 18 an die Basis des Schalttransistors 20 weiterzuleiten. Bei fehlendem Steuersignal wird das Ansteuersignal in der Sperrstufe 54 gesperrt.

Im Falle einer Fehlererkennung gibt die Überwachungsschaltung 22 zugleich mit der Wegnahme des Freigabesignals ein Ansteuersignal über eine Leitung 38 an eine Treiberschaltung 40 ab, deren Ausgang eine Kontrollampe 42 ansteuert. Die Kontrollampe 42 befindet sich im unmittelbaren Blickfeld des Fahrzeugbenutzers und fordert diesen bei Aktivierung auf, eine Werkstatt aufzusuchen, um den Fehler beheben zu lassen.

Nachdem ein Fehler gemeldet wurde, gibt die Überwachungsschaltung 22 über eine Leitung 44 ein Rücksetzsignal an den Mikrocomputer 14 ab. Durch dieses Rücksetzsignal wird der Mikrocomputer 14 initialisiert und veranlaßt, seinen Betrieb wiederaufzunehmen, was dann innerhalb einer kurzen Zeitspanne geschieht, sofern keine erneute Störung auftritt. Bei einer andauernden Störung gibt die Überwachungsschaltung 22 periodisch Rücksetzsignale über die Leitung 44 an den Mikrocomputer 14 ab. Währenddessen bleibt die Kontrollampe 42 aktiviert. Nach der Inbetriebnahme und nach jedem Rücksetzen des Mikrocomputers 14 bleibt das Freigabesignal auf Leitung 36 aus, bis die Überwachungsschaltung 22 alle relevanten Größen überprüft und keine Fehlfunktion festgestellt hat. Während dieser Zeitspanne kann der Mikrocomputer 14 kein Auslösesignal abgeben.

Außer der Frequenz des Prüfsignals überwacht die Überwachungsschaltung 22 auch die Betriebsspannung Vcc. Diese Überwachung geschieht mittels herkömmlicher Spannungskomparatoren. Wenn die Spannung Vcc außerhalb eines vorgeschriebenen Bereichs von beispielsweise 4,75 bis 5,25 V liegt, wird ein Fehler erkannt und das Freigabesignal auf Leitung 36 zurückgenommen sowie gleichzeitig über die Leitung 38 und die Treiberschaltung 40 die Kontrollampe 42 aktiviert.

Über eine getrennte Auswerteschaltung 46 wird die Kontrollampe 42 auch dann aktiviert, wenn ein über eine Leitung 48 vom Mikrocomputer 14 abgenommenes Prüfsignal, das von der Taktfrequenz des Mikrocomputers abgeleitet wird, keine Wechselspannungskomponente aufweist. Dieses Prüfsignal kann mit dem über die Leitung 32 an die Überwachungsschaltung 22 angelegten Signal identisch sein. Es wird durch Herunterteilen der Mikrocomputer-Taktfrequenz gewonnen. Die Auswerteschaltung 46 ist mit einem Lade/Entlade-Netzwerk versehen, worin ein Kondensator durch die Wechselspannungskomponente des Prüfsignals periodisch umgeladen wird und im Mittel die Ladespannung Null aufweist. Wenn die Wechselspannungskomponente ausbleibt, wird dieser Kondensator hingegen auf einen von Null verschiedenen Spannungswert aufgeladen. Diese Ladespannung führt zur Erzeugung eines Ansteuersignals für die Kontrollampe 42. Die Kontrollampe 42 wird also auch dann aktiviert, wenn das Taktsignal des Mikrocomputers 14 ausgefallen ist und zusätzlich die Überwachungsschaltung 22 defekt ist, so daß sie den Fehler nicht erkennt.

Es wird nun die Arbeitsweise der Steueranordnung beschrieben:

Der Beschleunigungsaufnehmer 10 liefert ein analoges Meßsignal, das der Fahrzeugbeschleunigung bzw. Verzögerung annähernd proportional ist. Der Anpassungsverstärker 12 verstärkt das Meßsignal um einen für die Weiterverarbeitung in dem Mikrocomputer 14 geeigneten Verstärkungsfaktor. Das verstärkte Meßsignal wird in dem Mikrocomputer 14 zunächst digitalisiert und dann einer Auswertung unterzogen. Die Auswertung erfolgt nach einem im Festwertspeicher des Mikrocomputers 14 abgelegten Programm. Wenn ein bestimmtes Auslösekriterium erfüllt ist, gibt der Mikrocomputer 14 über seinen Ausgang 18 ein Auslösesignal an die Basis des Schalttransistors 20 und zugleich über den Ausgang 24 das Auslösesignal an den Verzögerungskreis der Überwachungsschaltung 22 ab. Das um die feste Zeitspanne τ von beispielsweise 682 µs verzögerte Auslösesignal wird über die Leitung 26 an die Basis des Schalttransistors 28 angelegt. Wenn nach Ablauf der Zeitspanne τ das Auslösesignal am Ausgang 18 des Mikrocomputer 14 weiterhin vorhanden ist, bleibt der Schalttransistor 20 durchgeschaltet, und nunmehr wird auch der Schalttransistor 28 durchgeschaltet, so daß der elektrische Zünder 30 annähernd zwischen positiver Betriebsspannung und Masse liegt und somit aktiviert wird.

Wenn hingegen während der Zeitspanne τ die Überwachungsschaltung 22 einen Fehler feststellt, beispielsweise einen unzulässigen Wert der Betriebsspannung Vcc oder eine Abweichung von der Sollfrequenz des Mikrocomputer-Taktsignals, wird das sonst permanent vorhandene Freigabesignal von der Leitung 36 entfernt. Die Sperrstufe 54 sperrt, so daß der Schalttransistor 20 gesperrt bleibt. Das Ansteuersignal für den Schalttransistor 28 wird von der Überwachungsschaltung 22 nicht weitergegeben.

Die Überwachungsschaltung 22 gibt das Freigabesignal über die Leitung 36 immer dann an den Mikrocomputer 14 ab, wenn die Initialisierung erfolgt ist und kein Fehler festgestellt wird. Während der Initialisierung und immer dann, wenn ein Fehler auftritt, unterbleibt die Ausgabe des Freigabesignals und des Steuersignals, welches die Sperrstufe 54 entsperrt.

Zugleich mit der Wegnahme des Freigabesignals auf Leitung 36 erfolgt die Ansteuerung der Kontrollampe 42 in der bereits beschriebenen Weise.

In der Umgebung eines Kraftfahrzeugs sind Störungen in Form von Spannungsspitzen im Bordnetz oder Hochfrequenzeinstrahlungen oft anzutreffen. Sie treten aber in der Regel nur kurzzeitig auf. Wenn die Überwachungsschaltung 22 einen Fehler festgestellt hat, der auf solchen Störeinflüssen beruht, besteht eine große Wahrscheinlichkeit, daß anschließend ein fehlerfreier Betrieb des Mikrocomputers 14 möglich ist. Aus diesem Grunde gibt die Überwachungsschaltung 22 nach dem Auftreten eines Fehlers ein Rücksetzsignal über die Leitung 44 an den Mikrocomputer 14 ab, um diesen neu zu initialisieren. Wenn sich anschließend kein normaler Betrieb des Mikrocomputers einstellt, fährt die Überwachungsschaltung 22 fort, periodisch Rücksetzsignale über die Leitung 44 auszugeben.

Die Überwachungschaltung 22 enthält Einheiten wie Zähler und Komparatoren, deren Realisierung leicht in einer Technologie möglich ist, die eine relativ hohe Spannungsfestigkeit gewährleistet. Beispielsweise ist eine Realisierung der Überwachungsschaltung 22 in Form eines kundenspezifischen integrierten Schaltkreises möglich. Bei Wahl einer geeigneten Technologie für die Realisierung der Überwachungsschaltung 22 besteht eine sehr geringe Wahrscheinlichkeit, daß die Überwachungsschaltung defekt wird, wenn der Mikrocomputer noch einwandfrei arbeitet.

Um aber auch bei einem völligen Ausfall des Mikrocomputers und der Überwachungsschaltung eine Fehlermeldung ausgeben zu können, wird die Kontrollampe 42 über die Auswerteschaltung 46 auch dann aktiviert, wenn das Prüfsignal auf Leitung 48 keine Wechselspannungskomponente enthält, wenn also das Mikrocomputer-Taktsignal ganz ausbleibt.

## Patentansprüche

1. Steueranordnung für ein Rückhaltesystem in Kraftfahrzeugen, mit einem die von einem Beschleunigungaufnehmer abgegebenen Meßsignale auswertenden Mikrocomputer, der ein Auslösesignal an eine Auslösevorrichtung des Rückhaltesystems abgibt, wenn die Auswertung des Meßsignals ein Kriterium zur Aktivierung des Rückhaltesystems erfüllt,
**gekennzeichnet durch** eine bezüglich des Mikrocomputers externe Überwachungsschaltung (22), die
- ein von dem Mikrocomputer-Taktsignal abgeleitetes Prüfsignal mittels einer durch einen eigenen stabilen Oszillator angesteuerten Zähleinrichtung auf korrekte Frequenz überwacht;
- ein Freigabesignal erzeugt, wenn das Prüfsignal die korrekte Frequenz aufweist,
- eine Anzeigeeinrichtung (42) aktiviert, wenn das Prüfsignal als nicht korrekt befunden wird; und
- ansprechend auf den Wegfall des Freigabesignals die Abgabe des Auslösesignals an die Auslösevorrichtung (30) verhindert.

2. Steueranordnung nach Anspruch 1, **dadurch gekennzeichnet,** daß die Auslösevorrichtung (20, 28, 30) auf das gleichzeitige Vorhandensein von zwei Auslösesignalen anspricht, von denen das eine vom Mikrocomputer (14) direkt abgegeben wird und über eine bezüglich des Mikrocomputers (14) externe Sperrstufe (54) geführt ist, die von der Überwachungsschaltung (22) gesteuert wird, und von denen das andere in der Überwachungsschaltung (22) um eine feste Zeitspanne (τ) verzögert wird, die für die Überprüfung des Prüfsignals ausreicht, und daß die Sperrstufe (54) das Auslösesignal nur weitergibt, wenn das Freigabesignal vorhanden ist.

3. Steueranordnung nach Anspruch 1, **dadurch gekennzeichnet,** daß die Auslösevorrichtung zwei Schalttransistoren (20, 28) in Reihenschaltung mit einem elektrischen Zünder (30) aufweist, daß das vom Mikrocomputer (14) direkt abgegebene Auslösesignal an die Steuerelektrode des einen Schalttransistors (20) und das von der Überwachungsschaltung (22) abgegebene, verzögerte Auslösesignal an die Steuerelektrode des zweiten Schalttransistors (28) angelegt ist und daß die Reihenschaltung nur durchschaltet, wenn beide Ansteuersignale vorhanden sind.

4. Steueranordnung nach einem der vorstehenden Ansprüche, **dadurch gekennzeichnet,** daß die Überwachungsschaltung (22) auch die Betriebsspannungen (Vcc) überwacht und das Freigabesignal nur abgibt, wenn die Betriebsspannungen innerhalb der vorgesehenen Wertebereiche liegen.

5. Steueranordnung nach einem der vorstehenden Ansprüche, **dadurch gekennzeichnet,** daß die Überwachungsschaltung (22) ein Ansteuersignal an eine Kontrollampe (42) abgibt, wenn eine der von ihr überwachten Größen fehlerhaft ist.

6. Steueranordnung nach Anspruch 5, **dadurch gekennzeichnet,** daß die Kontrollampe (42) auch unabhängig von der Überwachungsschaltung (22) durch eine Auswerteschaltung (46) ansteuerbar ist, die das Prüfsignal auf Vorhandensein einer Wechselspannungskomponente auswertet und die Kontrollampe (42) ansteuert, wenn keine Wechselspannungskomponente vorhanden ist.

7. Steueranordnung nach einem der vorstehenden Ansprüche, **dadurch gekennzeichnet,** daß die Überwachungsschaltung (22) nach Erkennung eines Fehlerzustandes ein Rücksetzsignal an den Mikrocomputer (14) abgibt.

8. Steueranordnung nach Anspruch 7, **dadurch gekennzeichnet,** daß das Rücksetzsignal periodisch an den Mikrocomputer (14) abgegeben wird.

9. Steueranordnung nach einem der vorstehenden Ansprüche, **dadurch gekennzeichnet,** daß die Überwachungsschaltung (22) in einer Technologie ausgeführt ist, die gegenüber dem Mikrocomputer (14) eine erhöhte Spannungsfestigkeit aufweist.

## Claims

1. A control arrangement for a restraining system in motor cars comprising a microcomputer processing measured signals which are supplied by an acceleration pickup, said microcomputer supplying a trip signal to a trip device in said restraining system when the result of processing of said measured signal fulfills a criterion for activation of the restraining system,
characterized in a monitoring circuit (22) external to said microcomputer,said monitoring circuit
- monitoring as to correct frequency a check signal derived from the clock signal of said microcomputer using counting means which are driven by an associated stable oscillator;;
- producing an enable signal, when such check signal has its correct frequency;
- activating an indicating means (42), when the check signal is found to be incorrect; and
- in response to the disappearance of said enable signal, preventing the supply of the trip signal to said trip device (30).

2. The control arrangement as claimed in claim 1, characterized in that said trip device (20,28,30) is adapted to respond to the simultaneous presence of two trip signals, of which one is to be directly supplied by the microcomputer (14) via a blocking stage (54) which is external to the microcomputer (14) and which is controlled by the monitoring circuit (22), and of which the other is delayed in the monitoring circuit (22) by a fixed time interval (τ) which suffices for the monitoring of the check signal, and in that the blocking stage (54) is adapted only to pass on the trip signal when the enable signal is present.

3. The control arrangement as claimed in claim 1, characterized in that said trip device comprises two switching transistors (20,28) placed in a series circuit with an electrical trigger means (30), in that the trip signal supplied directly by the microcomputer (14) is to be applied to the control electrode of the one switching transistor (20) and the delayed trip signal from the monitoring circuit (22) is to be applied to the control electrode of the second switching transistor (28) and in that the series circuit arrangement is arranged only to become conducting when both the drive signals are present.

4. The control arrangement as claimed in any of the preceding claims,characterized in that said monitoring circuit (22) is also arranged to monitor the voltage (Vcc) of a power supply and to only supply said enable signal when said supply voltages are within prescribed value ranges.

5. The control arrangement as claimed in any of the preceding claims, characterized in that said monotoring circuit (22) is adapted to supply a drive signal to an indicator lamp (42) when one of a plurality of quantities monitored by it is at fault.

6. The control arrangement as claimed in claim 5, characterized in that said indicator lamp (42) is arranged also to be operated independently of the monitoring circuit (22) by an evaluating circuit (46), which processes the check signal to detect the presence of an AC component therein and to operate the indicator lamp (42) in the absence of an AC component.

7. The control arrangement as claimed in any of the preceding claims, characterized in that said monitoring circuit (22) is adapted to supply a reset signal to the microcomputer (14) after the detection of a fault condition.

8. The control arrangement as claimed in claim 7, characterized in that said reset signal is supplied periodically to said microcomputer (14).

9. The control arrangement as claimed any of the preceding claims, characterized in that said monitoring circuit (22) is established in a technology providing for a better breakdown voltage characteristic than the breakdown voltage of the microcomputer (14).

## Revendications

1. Dispositif de régulation pour un système de retenue sur des véhicules automobiles, comportant un micro-ordinateur qui analyse les signaux de mesure émis par un enregistreur de l'accélération et qui émet un signal de déclenchement à un dispositif de déclenchement du système de retenue lorsque l'analyse du signal de mesure est conforme à un critère d'activation dudit système de retenue, caractérisé par le fait qu'il comprend, à l'extérieur du micro-ordinateur, un circuit de surveillance (22) lequel,
- surveille la fréquence correcte d'un signal de contrôle dérivé du signal de synchronisation du micro-ordinateur au moyen d'un dispositif de comptage commandé par son propre oscillateur stable ;
- génère un signal de validation si le signal de contrôle est à la bonne fréquence ;
- active un dispositif indicateur (42) s'il s'avère que le signal de contrôle n'est pas correct ; et
- empêche l'émission du signal de déclenchement au dispositif déclencheur (30), en réponse à l'absence du signal de validation.

2. Dispositif de régulation selon la revendication 1, caractérisé par le fait que le dispositif de déclenchement (20, 28, 30) répond à la présence simultanée de deux signaux de déclenchement dont l'un est émis directement par le micro-ordinateur (14) et passe par une étape de blocage (54) extérieure au micro-ordinateur (14), laquelle est régulée par le circuit de surveillance (22), tandis que l'autre signal de déclenchement est retardé dans le circuit de surveillance (22) pendant un laps de temps fixe (τ) qui est suffisant pour contrôler le signal de contrôle, et par le fait que l'étape de blocage (54) ne transmet le signal de déclenchement qu'en cas de présence du signal de validation.

3. Dispositif de commande selon la revendication 1, caractérisé par le fait que la dispositif de déclenchement présente deux transistors (20, 28) montés en série, comportant un allumeur électrique (30), que le signal de déclenchement émis directement par le micro-ordinateur (14) est appliqué à l'électrode de commande de l'un des transistors (20) et que le signal de déclenchement retardé émis par le circuit de surveillance (22) est appliqué à l'électrode de commande du deuxième transistor (28), et que le montage en série n'ouvre le circuit qu'en cas de présence des deux signaux.

4. Dispositif de commande selon l'une des revendications précédentes, caractérisé par le fait que le circuit de surveillance (22) surveille également les tensions de service (Vcc) et n'émet le signal de validation que si lesdites tensions de service se situent à l'intérieur de plages prévues.

5. Dispositif de commande selon l'une des revendications précédentes, caractérisé par le fait que le circuit de surveillance (22) émet un signal de commande à une lampe témoin (42) si l'une des valeurs surveillées est erronée.

6. Dispositif de commande selon la revendication 5, caractérisé par le fait que la lampe témoin (42) peut aussi être commandée, indépendamment du circuit de surveillance (22), par un circuit d'analyse (46) qui analyse le signal de contrôle pour rechercher la présence d'une composante d'une tension alternative et qui active la lampe témoin (42) en l'absence de toute composante de tension alternative.

7. Dispositif de commande selon l'une des revendications précédentes, caractérisé par le fait que le circuit de surveillance (22) émet un signal de retour au micro-ordinateur (14) après détection d'un état d'erreur.

8. Dispositif de commande selon la revendication 7, caractérisé par le fait que le signal de retour est émis périodiquement au micro-ordinateur (14).

9. Dispositif de commande selon l'une des revendications précédentes, caractérisé par le fait que le circuit de surveillance (22) est réalisé selon une technologie qui présente une résistance aux tensions plus élevée que le micro-ordinateur (14).
